# EUROPEAN PATENT APPLICATION

(11) **EP 3 029 837 A1**
(43) Date of publication of application: **08.06.2016**
(21) Application number: 14382485.2
(22) Date of filing: 01.12.2014
(51) Int. Cl.: H03K 17/94, H01H 47/22

(54) **Proximity switch**

(71) Applicant: Hospital Clínic I Provincial de Barcelona, 08036 Barcelona (ES)
(72) Inventor: Viladevall i Ferrer, Xavier, 08036 Barcelona (ES); Agustín Bonaga, José, Manuel, 08036 Barcelona (ES); Lopez Silvo, Miguel, Angel, 08036 Barcelona (ES); Vila-Masana i Portabella, Joan, 08036 Barcelona (ES); Rodríguez Omedes, Fernando, 08036 Barcelona (ES)
(74) Representative: Carpintero Lopez, Francisco

(57) **Abstract**

The present invention relates to a proximity switch comprising a relay (3) which can be in an ON state and an OFF state; control means (2) connected with said relay (3); and a contactless detector (1) detecting the presence of an object close to it for sending a signal to the relay (3) through the control means (2) for switching the relay (3) from the OFF state to the ON state, or vice versa; and characterized in that the relay (3), control means (2) and detector (1) are electrically powered by means of a power supply network when the relay (3) is in the ON state and when it is in the OFF state.

The invention allows assuring cleanliness and eliminates the risk of fouling or contamination and allows use thereof with wet or dirty hands, since the electronic circuit can be hermetically isolated without jeopardizing operation.

## Description

The present invention relates to a proximity switch which can control a lamp or any other electric device, allowing contactless operation, by detecting the presence of a nearby object such as the user's hand.

### Background of the Invention

Conventional domestic switches are mechanical switches that do not have any electronic circuit therein. For that reason, they do not need a power supply to operate.

Their wiring is limited to wires necessary for connecting to and disconnecting from the load they control. The simplest type of switch needs only 2 wires and contact of the user's hand with the switch is essential to operate same.

There are also TRIAC-based electronic switches having an electronic circuit therein. These switches are powered by the electric current the lamp consumes or the load they control, and for that reason they can only work while the load is switched on.

This prevents these switches from being able to be operated in a contactless manner because while they are switched off, the control circuit does not receive a power supply and would be unable to detect the presence of the user's hand trying to connect it.

Other infrared switches that control lamps or other loads and are operated in a contactless manner are also known. The control circuit of these switches must permanently receive a power supply regardless of the state of the lamp they control. In these cases, it is essential to add additional cables to the wiring system that would correspond to a conventional switch.

Finally, there are also electronic switches operated in a contactless manner that obtain power supply from rechargeable batteries or cells. This prevents the need for additional wiring but generates the need for frequent maintenance to replace fungible elements.

The need for a proximity switch which can be operated in a contactless manner and does not need cables or additional elements to operate is therefore obvious.

### Description of the Invention

The proximity switch of the invention successfully solves the mentioned drawbacks and has other advantages that will be described below.

The proximity switch according to the present invention comprises a relay which can be in an ON state and an OFF state; control means connected with said relay; and a contactless detector detecting the presence of an object close to it for sending a signal to the relay through the control means for switching the relay from the OFF state to the ON state, or vice versa; and it is characterized in that the relay, control means and detector are electrically powered by means of a power supply network when the relay is in the ON state and when it is in the OFF state.

Advantageously, the proximity switch according to the present invention also comprises a voltage regulator providing continuous power supply to the relay, control means and detector.

Furthermore, said voltage regulator is preferably connected to a current transformer, powering the voltage regulator when the relay is in the ON state, and said voltage regulator is preferably connected to a voltage transformer, powering the voltage regulator when the relay is in the OFF state.

Preferably, the current transformer is connected with said relay, and the voltage transformer is connected with input terminals for supplying power to said relay.

According to a preferred embodiment, the relay is a bistable electromagnetic relay and the detector is an infrared detector. Said infrared detector detects the presence of an object preferably by means of pulse trains and triangulation for measuring the distance between the object and the detector.

Furthermore, the proximity switch according to the present invention also advantageously comprises a voltage zero-crossing detector connected to said control means which allow the relay state change at optimal times.

A voltage rectifier is preferably arranged between the current transformer and voltage regulator and/or between the voltage transformer and voltage regulator.

If desired, the proximity switch according to the present invention can also comprise a pilot light connected with said control means and/or an indicator light connected with said control means.

Optionally, the proximity switch can also comprise a data transfer connector connected to said control means.

Advantageously, said control means are a microcontroller.

The present invention is a switch that overcomes the limitations of switches existing today since it can be operated in a contactless manner and does not need additional cables to operate because the power supply is obtained from the same wires that would correspond to a conventional switch.

In the switch according to the present invention, the power supply necessary for the operation of the electronic control circuit is obtained from the actual electric power supplied to the lamp or load.

As a result of the absence of contact with the switch, cleanliness is assured and the risk of fouling or contamination is eliminated. The invention allows use thereof with wet or dirty hands, since the electronic circuit can be hermetically isolated without jeopardizing operation. Furthermore, the possibility of being installed in existing boxes having standard mechanisms without having to modify the wiring, make it very suitable for replacing conventional switches in sensitive clinic or hospital settings.

### Brief Description of the Drawings

To better understand the foregoing, drawings are attached in which a practical embodiment is schematically depicted only by way of non-limiting example.

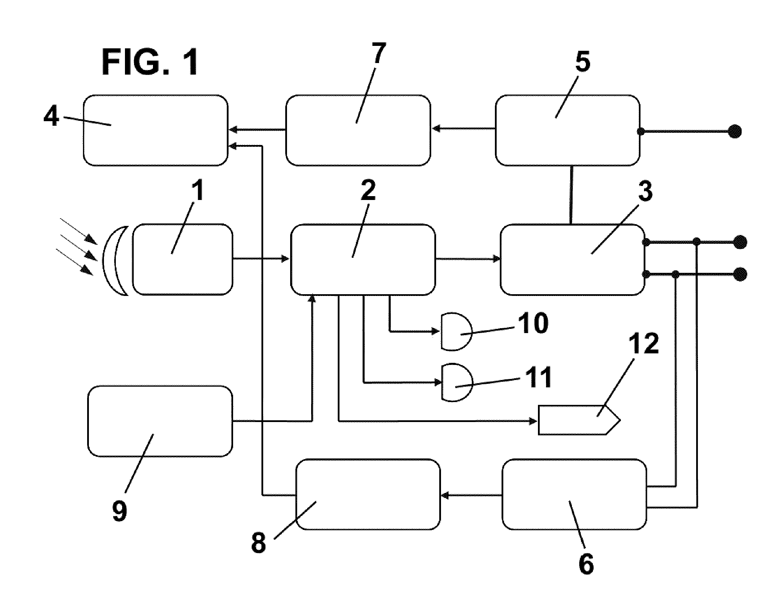

Figure 1 is a block diagram of the components of the proximity switch according to the present invention.

### Description of a Preferred Embodiment

The proximity switch comprises a relay 3 which can be in an ON state and an OFF state, control means 2 connected with said relay 3; and a contactless detector 1 detecting the presence of an object close to it for sending a signal to the relay 3 through the control means 2 for switching the relay 3 from the OFF state to the ON state, or vice versa.

The switch is preferably used for switching a lamp on and off.

In the switch according to the present invention, contactless operation is achieved by means of said detector 1, preferably an infrared detector, detecting the infrared radiation reflected by a nearby object, such as the user's hand.

The detector 1 is associated with filters to assure that the detector 1 is not influenced by infrared light in the environment or by infrared radiation emitted by other common devices (remote controls for televisions, air conditioning systems, etc.). For example, the infrared radiation is emitted in pulse trains, which assures that the detector is not affected by other similar switches that may be located nearby.

The infrared detector 1 works by triangulation and measures the distance at which the object is located. The detector 1 is calibrated to react to objects located at least 5 cm away, for example.

The lamp is controlled by means of said relay 3, which is preferably a bistable electromechanical relay. The fact that it is an electromechanical relay instead of a TRIAC or solid-state relay allows covering all cases of simple switches or cross-point switches. It is even possible to combine conventional switches with the switches of this invention in one and the same installation since the wiring is the same.

The fact that the relay 3 is bistable and not monostable reduces power consumption to limits that are compatible with self-powered operation. Unlike a conventional monostable relay, a bistable relay has two stable states (ON and OFF), such that it does not require a power supply to maintain any of the two states. Power supply is not necessary when switching between the two states corresponding to the time when switching on or off.

The bistable relay 3 incorporated in the switch of the present invention has two coils which can be activated individually. Once the corresponding coil is activated, the relay 3 will maintain its state indefinitely, even though current passage through its coil ceases.

This operation reduces power consumption with respect to the consumption of a conventional relay and allows limiting the size of the current transformer so that it fits in the available volume.

The power supply of the electronic control circuit, including the detector 1, relay 3 and control means 2, formed by a microcontroller, for example, is obtained by means of the power supply from the cables connected to the power network connecting with the lamp.

There are two different operating principles depending on the state of the lamp:
- ON cycle (the lamp is on):
   In this case, the current circulating through the lamp also goes through the relay 3 of the switch, and it is also circulated through the primary circuit of a current transformer 5 integrated in the switch. This generates a current in the secondary circuit which is proportional to the current of the primary circuit and powers the control circuit (detector 1, microcontroller 2 and relay 3). The current in the primary circuit must be less than the maximum current that the circuit can withstand in order to not destroy same, but it must also be greater than the minimum necessary so that the control circuit receives enough power supply. These two values determine the acceptable current range of the lamp which allows the switch to work correctly.

This current transformer 5 is connected to a voltage regulator 4 generating a continuous power supply of 5 volts, for example. A voltage rectifier-balancer 7 is arranged between the current transformer 5 and voltage regulator 4.
- OFF cycle (the lamp is off):
   In this case, the current transformer 5 does not generate any current in its secondary circuit since there is no current in the primary circuit. The voltage that would be applied to the lamp is in the terminals of the relay 3 because the circuit is open. The power supply of the control circuit is obtained, in this case, by means of a voltage transformer 6 connected to the terminals of the relay 3. It is of interest to note that this voltage transformer 6 does not generate any voltage in the ON cycle, since in that case the relay 3 is closed and voltage between its terminals is 0.

The primary circuit of the voltage transformer 6 is connected to the terminals of the relay 3. An AC voltage is generated in the secondary circuit, said voltage being rectified and filtered through a rectifier 8 before being sent to the voltage regulator 4, generating a continuous power supply of 5 volts, for example.

The switch according to the present invention also comprises a voltage zero-crossing detector 9 which is preferably formed by two diodes and two resistances, extracting a signal from the secondary circuit which allows the microcontroller 2 to detect voltage zero-crossing.

This voltage zero-crossing detection allows using the switch according to the present invention with inductive loads.

When the lamp is off, the relay 3 will be connected at the time of voltage zero-crossing, which will coincide with the intensity zero-crossing, and when the lamp is on, the relay 3 will be disconnected at the time of current zero-crossing.

A relay is an electromechanical device and therefore has certain inertia. Disconnection of the terminals of the relay does not occur immediately when the relay receives the activation current pulse in the coil, but will take some time which can be of a few milliseconds. Given that the wave half-period of a 220-V AC supply voltage is 10 ms (at 50 Hz), the time delay of the relay is very significant. The microcontroller 2 is calibrated to take this into account and to advance the activation signal for disconnection at the time of zero-crossing.
- Switching between cycles:
   In some types of lamps, the current does not immediately reach its maximum value upon connection, but takes some time to stabilize. To assure power supply in these cases, the switch incorporates capacitors (not depicted in the drawings) accumulating the necessary power.

The microcontroller 2 of the electronic control circuit comprises the connections necessary for detecting current and voltage zero-crossing. This allows connecting and disconnecting the relay at optimal times, such that resistive loads (incandescent light bulbs, stoves, etc.) as well as inductive loads (fluorescent tubes, transformers, motors, etc.) can be controlled.

The switch is designed for being adapted to existing boxes having standard mechanisms and advantageously comprises an indicator light (LED) 11 that lights up briefly to indicate that the user's hand has been detected. It also comprises a pilot light (LED) 10 to facilitate positioning thereof in the absence of light.

The switch can also comprise a standard USB connector 12 which optionally allows connecting it to a computer for programming operating parameters.

Although reference has been made to a specific embodiment of the invention, it is obvious for a person skilled in the art that the proximity switch that has been described is susceptible to a number of variations and modifications, and that all the mentioned details can be replaced with other technically equivalent details, without departing from the scope of protection defined by the attached claims.

## Claims

1. Proximity switch comprising:
- a relay (3) which can be in an ON state and an OFF state;
- control means (2) connected with said relay (3); and
- a contactless detector (1) detecting the presence of an object close to it for sending a signal to the relay (3) through the control means (2) for switching the relay (3) from the OFF state to the ON state, or vice versa;
**characterized in that** the relay (3), control means (2) and detector (1) are electrically powered by means of a power supply network when the relay (3) is in the ON state and when it is in the OFF state.

2. Proximity switch according to claim 1, comprising a voltage regulator (4) providing continuous power supply to the relay (3), control means (2) and detector (1).

3. Proximity switch according to claim 2, wherein said voltage regulator (4) is connected to a current transformer (5), powering the voltage regulator (4) when the relay is in the ON state.

4. Proximity switch according to claim 2 or 3, wherein said voltage regulator (4) is connected to a voltage transformer (6), powering the voltage regulator (4) when the relay (3) is in the OFF state.

5. Proximity switch according to claim 3, wherein the current transformer (5) is connected with said relay (3).

6. Proximity switch according to claim 4, wherein the voltage transformer (4) is connected with input terminals for supplying power to said relay (3).

7. Proximity switch according to claim 1, wherein the relay (3) is a bistable electromagnetic relay.

8. Proximity switch according to claim 1, wherein the detector (1) is an infrared detector.

9. Proximity switch according to claim 8, wherein the infrared detector (1) detects the presence of an object by means of pulse trains and triangulation for measuring the distance between the object and the detector (1).

10. Proximity switch according to claim 1, also comprising a voltage zero-crossing detector (9) connected to said control means (2).

11. Proximity switch according to claim 3 or 4, wherein a voltage rectifier (8) is arranged between the current transformer (5) and voltage regulator (4) and/or between the voltage transformer (6) and voltage regulator (4).

12. Proximity switch according to claim 1, also comprising a pilot light (10) connected with said control means (2).

13. Proximity switch according to claim 1, also comprising an indicator light (11) connected with said control means (2).

14. Proximity switch according to claim 1, also comprising a data transfer connector (12) connected to said control means (2).

15. Proximity switch according to claim 1, 2, 10, 12, 13 or 14, wherein said control means (2) are a microcontroller.
